# EUROPÄISCHE PATENTANMELDUNG

(11) **EP 2 019 423 A2**
(43) Veröffentlichungstag der Anmeldung: **28.01.2009**
(21) Anmeldenummer: 08104715.1
(22) Anmeldetag: 11.07.2008
(51) Int. Cl.: H01L 21/98, H01L 25/07, H01L 21/56, H01L 25/18

(54) **Einheitliche Leistungspackages unabhängig von der Bauelementzusammenstellung**

(30) Priorität: 26.07.2007 DE 102007034949
(71) Anmelder: Siemens Aktiengesellschaft, 80333 München (DE)
(72) Erfinder: Kaltenbacher, Axel, 85737, Ismaning (DE); Weinke, Robert, 81825, München (DE); Kaspar, Michael, 85640, Putzbrunn (DE); Schimetta, Gernot, 81541, München (DE); Weidner, Karl, 81245, München (DE); Zapf, Jörg, 81927, München (DE)

(57) **Zusammenfassung**

Die vorliegende Erfindung betrifft eine Vielzahl von Einzelpackages (1) mit jeweils einer Bauelementzusammenstellung mit mindestens einem zunächst ungehäusten elektronischen Bauelement (6), insbesondere Leistungsbauelement oder Leistungshalbleiterbauelement, insbesondere für Hochspannungen größer 1000V, wobei das Bauelement (6) Anschlussflächen zur elektrischen Kontaktierung (4) des Bauelements (6) und/oder zur Befestigung (5) des Bauelements (6) aufweist, sowie deren Herstellung und Verwendung. Es soll ein kostengünstiger Aufbau derart bereitgestellt werden, dass die Bauelementzusammenstellungen auf einfache Weise elektrisch kontaktierbar und/oder einfach zu befestigen sind. Dazu werden die Einzelpackages (1) hinsichtlich Form und Abmessungen einer elektrisch isolierenden Bauelementumhüllung (2) unabhängig von der Bauelementzusammenstellung vereinheitlicht. Auf diese Weise können Hochleistungshalbleiterbauelemente, insbesondere für den Hochspannungsbereich größer 1000V, einfach geschaffen und beispielsweise als Wechselrichter, Gleichrichter, Gleichstromsteller, Frequenzumformer und dergleichen verwendet werden.

## Beschreibung

Die vorliegende Erfindung betrifft eine Vielzahl von Einzelpackages gemäß dem Oberbegriff des Hauptanspruchs und dazugehörige Herstellungsverfahren.

Insbesondere in der Leistungselektronik wird eine Anzahl zunächst ungehäuster Chips und/oder zunächst ungehäuster passiver Bauelemente in Verbindung mit einer Bauelementzusammenstellung verwendet. Dabei sind derartige elektronische Bauelemente in Größe und Form sehr unterschiedlich. Dies betrifft ebenso Anschlussflächen zur elektrischen Kontaktierung beziehungsweise Anschlussflächen zur Befestigung beispielsweise auf Substraten. Auf dieser Grundlage ist ein Aufbau entsprechender Schaltungen kostenintensiv.

Herkömmlicher Weise wird eine DCB-Keramik als Substrat verwendet, wobei auf dessen Vorderseite Bauelemente gelötet werden. DCB steht für "Direct Copper Bonding". Elektrische Kontaktierungen erfolgen mittels Dickdrahtbonden und Silikonverguss oder alternativ planar. Bei einem planaren Kontaktieren gemäß der WO 03030247 wird das Dickdrahtbonden durch Laminieren einer Isolationsfolie ersetzt. Es schließen sich ein Öffnen von Kontaktfestern durch Laserablation und das Erzeugen einer planaren Verbindung durch galvanisch abgeschiedenes Metallisieren an. Der gesamte Inhalt der WO 03030247 gehört ausdrücklich zur Offenbarung der vorliegenden Anmeldung.

Es ist Aufgabe der vorliegenden Erfindung bei Bauelementzusammenstellungen von mindestens einem zunächst ungehäusten elektronischen Bauelement, insbesondere Leistungsbauelement oder Hochleistungshalbleiterbauelement, insbesondere für einen Hochspannungsbereich größer 1000V und insbesondere einem aktiven Bauelement, einen kostengünstigen Aufbau derart bereit zu stellen, dass die Bauelementzusammenstellungen auf einfache Weise elektrisch kontaktierbar und/oder einfach zu befestigen sind. Insbesondere soll nach einer Montage eine hohe Zuverlässigkeit bei elektrischer und thermischer Zykelbeanspruchung geschaffen sein. Elektrische Zykelbeanspruchung bedeutet das abwechselnde Aussetzen unter einer niedrigen elektrischen Leistung und einer hohen elektrischen Leistung mit einer bestimmten Anzahl von Lastwechseln. Thermische Zykelbeanspruchung bedeutet das abwechselnde Aussetzen unter einer niedrigen Temperatur, beispielsweise -40°C, und einer hohen Temperatur, beispielsweise +125°C, mit einer bestimmten Anzahl von Temperaturwechseln, beispielsweise 100 bis 1000 Zykeln. Zudem sollen für eine elektrische Isolation hochstabile Werkstoffe verwendbar sein, die sich nicht in Folien oder Lackform verarbeiten lassen.

Die Aufgabe wird durch eine Vielzahl von Einzelpackages gemäß dem Hauptanspruch gelöst. Die vorgeschlagene Vielzahl von Einzelpackages wird mittels eines Verfahrens gemäß dem Nebenanspruch erzeugt.

Grundlage ist eine Bauelementumhüllung oder Verkapselung von einem oder mehreren elektronischen Bauelementen, insbesondere Hochleistungshalbleiterbauelementen, insbesondere für einen Hochspannungsbereich größer 1000V, insbesondere aktive Bauelementen, in jeweils einem einheitlich normierten Einzelpackage. Die Einzelpackages sind hinsichtlich deren Eigenschaften einheitlich normierbar. Diese betreffen beispielsweise die elektrische und mechanische Befestigung sowie die Funktion. Ein einheitlich normiertes Einzelpackage weist, insbesondere mit einer einheitlich normierten elektrisch isolierenden Bauelementumhüllung, grundsätzlich beliebige weitere einheitlich normierbare Eigenschaften auf, und zwar unabhängig oder abhängig von der Bauelementzusammenstellung in dem jeweiligen Einzelpackage. Auf diese Weise kann ein kostengünstiger normierter Aufbau von elektronischen Schaltungen, insbesondere Leistungshalbleiterschaltungen oder Hochleistungshalbleiterschaltungen bereitgestellt werden. Durch den normierten Aufbau können elektronische Schaltungen besonders einfach und kostengünstig geschaffen und in beliebige Vorrichtungen integriert werden. Einheitlich normiert bedeutet, dass Einzelpackages hinsichtlich bestimmter Eigenschaften klar in Gruppen eingeteilt werden können.

Weitere vorteilhafte Ausgestaltungen finden sich in den Unteransprüchen.

Gemäß den vorteilhaften Ausgestaltungen sind die einheitlich normierten Eigenschaften eines Einzelpackages die äußere geometrischen Form und/oder die Abmessungen der Bauelementumhüllung, die Zugänge zu den Anschlussflächen, der thermische Ausdehnungskoeffizient, die Temperaturfestigkeit und/oder die Dielektrizitätszahl. Grundsätzlich sind weitere vorteilhafte physikalische, mechanische und chemische Eigenschaften der Bauelementumhüllung ebenso einheitlich normierbar. Des Weiteren sind ebenso die gesamten Einzelpackages hinsichtlich deren Eigenschaften einheitlich normierbar. Diese betreffen insbesondere die elektrische und mechanische Befestigung sowie die Funktion.

Gemäß einer vorteilhaften Ausgestaltung weist eine elektrisch isolierende Bauelementumhüllung für alle Bauelementzusammenstellungen eine einheitlich normierte äußere geometrische Form und/oder einheitlich normierte Abmessungen auf, und zwar unabhängig von der Bauelementzusammenstellung in dem jeweiligen Einzelpackage. Auf diese Weise sind alle erzeugten Einzelpackages hinsichtlich der dreidimensionalen äußeren Abmessungen identisch. Das heißt, durch die entsprechende Bereitstellung der Bauelementumhüllung kann eine vorteilhafte Normierung auf bestimmte Bauformen und Größen bereitgestellt werden. Es ist leicht ersichtlich, dass auf diese Weise alle Einzelpackages lediglich den gleichen Raum, beispielsweise auf einer Leiterplatte, in einer herzustellenden beliebigen Vorrichtung benötigen, unabhängig von der Funktion der Bauelementzusammenstellung. Auf diese Weise wird die Planung der Vorrichtung stark vereinfacht, da der benötigte Raum je Einzelpackage immer gleich ist.

Gemäß einer weiteren vorteilhaften Ausgestaltung weist jedes Einzelpackage, bei gleicher Bauelementzusammenstellung, einheitlich normierte Zugänge, zu den Anschlussflächen zur elektrischen Kontaktierung und/oder zur Befestigung, in der elektrisch isolierenden Bauelementeumhüllung auf. Auf diese Weise sind alle Einzelpackages einer Bauelementzusammenstellung einheitlich und besonders einfach elektrisch kontaktierbar und/oder auf einem Substrat befestigbar.

Gemäß einer weiteren vorteilhaften Ausgestaltung weisen die einheitlich normierten Zugänge zu den Anschlussflächen eine Durchführung durch die Bauelementumhüllung von der Oberseite zur Unterseite des Bauelements, eine Zuführung auf der Oberfläche der Bauelementumhüllung von der Oberseite zur Unterseite des Bauelements und/oder eine Rinne von der Oberseite des Einzelpackages zu den Anschlussflächen auf der Oberseite des Bauelements auf. Auf diese Weise kann das elektrische Kontaktieren einfach erfolgen.

Gemäß einer weiteren vorteilhaften Ausgestaltung weist die Bauelementumhüllung ein Material mit einem einheitlich normierten an ein Substrat angepassten thermischen Ausdehnungskoeffizienten auf. Ebenso kann die isolierende Schicht der Bauelementumhüllung beispielsweise aus einem Material mit einem einheitlich normierten an das Substrat angepassten thermischen Ausdehnungskoeffizienten bestehen. Auf diese Weise weisen die Einzelpackages eine hohe Zuverlässigkeit bei elektrischer und/oder thermischer Zykelbeanspruchung auf. Auf diese Weise ist eine Anpassung von Ausdehnungskoeffizient von Substrat und Isolator derart möglich, dass eine hohe thermomechanische und/oder elektrische Zykelfestigkeit ausgebildet wird.

Gemäß einer weiteren vorteilhaften Ausgestaltung weist die Bauelementumhüllung ein einheitlich normiertes hochtemperaturfestes Material auf. Es können hochstabile Werkstoffe verwendet werden, welche sich nicht in Folien und Lackform verarbeiten lassen, wie dies beispielsweise PEEK, LCP, Moldmassen und dergleichen sind. Auf diese Weise sind die erzeugten Einzelpackages besonders vorteilhaft für Hochleistungshalbleiter, insbesondere für einen Hochspannungsbereich größer 1000V, verwendbar. Alternativ oder kumulativ weist die Bauelementumhüllung ein Material mit einer einheitlich normierten Dielektrizitätszahl derart auf, dass bestimmte Spannungsfestigkeiten entsprechend den verwendeten Spannungsebenen der Einzelpackages erzeugt sind.

Gemäß einer weiteren vorteilhaften Ausgestaltung sind die Anschlussflächen zur Befestigung des mindestens einen elektronischen Bauelements auf einfache Weise einheitlich normiert lötbar und/oder schweißbar. Das heißt, es werden löt- und/oder schweißbare Anschlusspads zur Montage eines Einzelpackages auf entsprechenden Substraten bereitgestellt. Der vorgeschlagene Aufbau stellt löt- und/oder schweißbare Chip-Einzelpackages bereit. Damit sind weitere Abstufungen der Einzelpackages erzeugbar.

Gemäß einer weiteren vorteilhaften Ausgestaltung sind die Anschlussflächen zur Kontaktierung durch die einheitlich normierten Zugänge planar oder oberflächenmontiert(surface mounted technology, SMT) aus der Bauelementumhüllung herausgeführt. Das heißt, die weitere Kontaktierung der Bauelemente zum Aufbau herausgeführter Kontaktflächen kann planar erfolgen. In diesem Zusammenhang sei auf die Offenbarung der WO 03030247 hingewiesen. Die Kontaktierung wird mittels der Prozessschritte gemäß der WO 03030247 erzeugt. Beispielsweise sind diese Schritte vollflächiges Sputtern einer Basismetallisierung, Aufbringen, Belichten und Entwickeln einer lichtempfindlichen Schicht, Galvanisieren der Zugänge, Entfernen der lichtempfindlichen Schicht, Rückätzen der Basismetallisierung, abschließendes Erzeugen eines metallischen, insbesondere Kupfer aufweisenden, Zugangs. Gemäß einer weiteren Ausgestaltung sind die Anschlussflächen der Bauelemente auf eine Seite geführt. Damit kann ein Verbauen mittels SMT-Technologie geschaffen werden. Damit sind ebenso weitere Abstufungen der Einzelpackages hinsichtlich deren Eigenschaften erzeugbar. Insbesondere mit der Planartechnik ist eine niederinduktive Kontaktierung der elektronischen Bauelemente bereitstellbar.

Gemäß einer weiteren vorteilhaften Ausgestaltung sind die verwendeten elektronischen Bauelemente IGBTs (Insulated Gate Bipolar Transistors), Thyristoren, Dioden und/oder Hochleistungshalbleiterchips oder Leistungshalbleiterchips. Dabei umfasst ein Einzelpackage beliebige Bauelementzusammenstellungen beispielsweise aus diesen Bauelementen. Ebenso kann eine Vielzahl von gleichen Bauelementen verwendet werden. Damit sind ebenso weitere Abstufungen der Einzelpackages hinsichtlich deren Eigenschaften erzeugbar. Es kann ein Anordnen der Bauelemente einer Bauelementzusammenstellung eines Einzelpackages entsprechend deren Funktion ausgeführt sein. Besonders vorteilhaft können damit beispielsweise Hochspannungsschaltungen zusammengestellt werden. Beispielsweise kann eine Funktionseinteilung in Gleichrichter oder Leistungssteuerungen erfolgen.

Gemäß einem Verfahren gemäß dem Nebenanspruch zur Erzeugung einer Vielzahl von Einzelpackages, wobei Einzelpackages ebenso unterschiedliche Bauelementzusammenstellungen aufweisen können, erfolgt ein Erzeugen einer elektrisch isolierenden Bauelementumhüllung mit einheitlich normierten grundsätzlich beliebigen Eigenschaften mittels Fixieren der jeweils einem Einzelpackage zugeordneten ungehäusten Bauelemente mit deren Anschlussflächen zur Befestigung auf einer Trägerfolie, und Erzeugen jeweils eines hinsichtlich beliebiger Eigenschaften einheitlich normierten Einzelpackages mit insbesondere einer einheitlich normierten elektrisch isolierenden Bauelementumhüllung für jedes Einzelpackage, auf allen Flächen der, den Einzelpackages zugeordneten, ungehäusten Bauelemente, außer deren Anschlussflächen zur Befestigung auf der Trägerfolie. Es ist ein besonders kostengünstiges Verfahren zur Herstellung von normierten Einzelpackages bereitstellbar.

Gemäß dem Verfahren werden jeweils ungehäuste elektronische Bauelemente auf einer Trägerfolie entsprechend ihrer gewünschten Funktion angeordnet. Die elektronischen Bauelemente sind beispielsweise einzelne IGBT-Chips, Kombinationen aus IGBTs und Dioden, kleinere IGBTs in einem Doppelpackage oder in einem Package zu dritt und dergleichen. Da die Anschlussflächen zur Befestigung auf der Trägerfolie aufliegen, sind diese Anschlussflächen frei von der Bauelementumhüllung. Dies erleichtert ein Abheben von der Trägerfolie und ein Aufsetzen eines Einzelpackages auf ein Substrat, beispielsweise auf eine Leiterplatte einer beliebigen Vorrichtung.

Gemäß einer weiteren vorteilhaften Ausgestaltung werden gleiche Einzelpackages derart erzeugt, dass auf einfache Weise sogenannte Gurte für Pick-and-Place-Maschinen bereitgestellt werden können.

Gemäß einer weiteren vorteilhaften Ausgestaltung wird die Vielzahl von Einzelpackages auf der Trägerfolie gleichzeitig erzeugt. Auf diese Weise ist die Herstellung zeitsparend ausführbar.

Gemäß einer vorteilhaften Ausgestaltung erfolgt das Erzeugen der Bauelementumhüllung mittels Molding, Vergießens oder Spritzguss. Durch einen Aufbau mittels Spritzgussverfahrens lassen sich insbesondere hochstabile Werkstoffe verwenden, welche sich nicht in Folien oder Lackform verarbeiten lassen, beispielsweise PEEK, LCP, Moldmassen und dergleichen. Die vorstehend genannten Bauelemente werden in einem nachfolgenden Verfahren mittels Mold- oder Vergusstechnologie mit einer Isolationsschicht der Bauelementumhüllung umschlossen. Ein verwendeter Mold/Verguss-Prozess ist besonders kostengünstig.

Gemäß einer weiteren vorteilhaften Ausgestaltung erfolgt das Erzeugen der Zugänge zu Anschlussflächen, insbesondere zu den Anschlussflächen zur Kontaktierung, mittels erster Aussparungen in der Bauelementumhüllung. Das heißt, geeignete Stellen, wie beispielsweise die Kontaktoberflächen des elektronischen Bauelements, sind von der Bauelementumhüllung beziehungsweise der Isolationsschicht unbedeckt.

Gemäß einer weiteren vorteilhaften Ausgestaltung erfolgt ein Erzeugen der Zugänge zu Anschlussflächen, insbesondere zur Kontaktierung, mittels Bereitstellen der Bauelementumhüllung, allerdings mit einer, im Vergleich zu einer durchschnittlichen Dicke sehr geringen Dicke an den Stellen der Anschlussflächen. Es schließt sich ein Entfernen des verbleibenden Restes mittels Ablation, insbesondere Laserablation, an. Das heißt, etwaiges dünnstes Restmaterial, das sich zwischen den Aussparungen und Anschlussflächen zur Kontaktierung befinden kann, kann mittels Ablation beispielsweise mittels Laserablation entfernt werden. Nach einem Entfernen oder nach einer Ablation können folgende Schritte, und zwar vollflächiges Sputtern einer Basismetallisierung; Aufbringen, Belichten und Entwickeln einer lichtempfindlichen Schicht; Galvanisieren der Zugänge; Entfernen der lichtempfindlichen Schicht; Rückätzen der Basismetallisierung; abschließendes Erzeugen von metallischen, insbesondere Kupfer aufweisenden, Zugängen; ausgeführt werden.

Gemäß einer weiteren vorteilhaften Ausgestaltung werden Vereinzelungspositionen zwischen angrenzenden Einzelpackages mittels zweiter Aussparungen und/oder Ausdünnungen in der Bauelementumhüllung erzeugt. Auf diese Weise können Einzelpackages einfach vereinzelt werden.

Gemäß einer weiteren vorteilhaften Ausgestaltung erfolgt ein Erzeugen von aus der Bauelementumhüllung herausgeführten Anschlussflächen zur Kontaktierung beispielsweise planar. Auf diese Weise wird mittels dicker Verbindungen aus elektrisch hochleitfähigem Material gemäß dem planaren elektrischen Kontaktierverfahren gemäß der WO 03030247 gehört, eine hohe Stromtragfähigkeit bereitgestellt. Alternativ sind die Anschlussflächen zur Kontaktierung der Bauelemente auf eine Seite herausgeführt, so dass die elektronischen Bauelemente oberflächenmontiert bereitgestellt werden können. Auf diese Weise sind Einzelpackages in zwei Kontaktierarten einteilbar, und damit hinsichtlich der elektrischen Kontaktierung einheitlich normiert.

Gemäß einer weiteren vorteilhaften Ausgestaltung werden erzeugte Einzelpackages von der Trägerfolie mittels sogenannter Pick- and Place-Maschinen abgehoben beziehungsweise abgenommen. Auf diese Weise sind die erzeugten Einzelpackages leicht in einen Produktionsprozess integrierbar.

Gemäß einer weiteren vorteilhaften Ausgestaltung werden Einzelpackages auf jeweilige Substrate mittels der Anschlussflächen zur Befestigung aufgebracht.

Gemäß einer weiteren vorteilhaften Ausgestaltung erfolgt ein Befestigen von Einzelpackages mittels Löten und/oder Schweißen auf jeweiligen Substraten. Es können herkömmliche Löt- oder Schweißverfahren angewendet werden. Es werden, jeweils für jedes Einzelpackage, und zwar abhängig von der Bauelementzusammenstellung, einheitlich normierte elektrische Kontaktierungen und/oder mechanische Befestigungen erzeugt. Auf diese Weise können Löt- und/oder Schweißverbindungen der Anschlussflächen der Bauelemente auf Substrate bereitgestellt werden. Damit ist ebenso ein kostengünstiger normierter Aufbau von elektronischen Schaltungen, insbesondere bei Hochleistungshalbleitern, erzeugbar.

Gemäß einer weiteren Ausgestaltung erfolgt ein planares oder oberflächenmontiertes (SMT) Erzeugen von aus der Bauelementumhüllung herausgeführten metallischen Zugängen zur elektrischen Kontaktierung, nach dem Positionieren eines Einzelpackages auf einem Substrat. Damit ist eine Anpassung eines Packages an ein Substrat erst am Ende der Erzeugung einer Vorrichtung erforderlich.

Die vorliegende Erfindung ist anhand von Ausführungsbeispielen in Verbindung mit den Figuren näher beschrieben. Es zeigen:
- Figur 1: ein erstes Ausführungsbeispiel einer Vielzahl von Einzelpackages;
- Figur 2: ein zweites Ausführungsbeispiel einer Vielzahl von Einzelpackages;
- Figur 3: ein drittes Ausführungsbeispiel einer Vielzahl von Einzelpackages;
- Figur 4: ein viertes Ausführungsbeispiel einer Vielzahl von Einzelpackages;
- Figur 5: ein Ausführungsbeispiel eines Verfahrens zur Erzeu- gung einer Vielzahl von Einzelpackages 1 und deren Weiterverarbeitung.

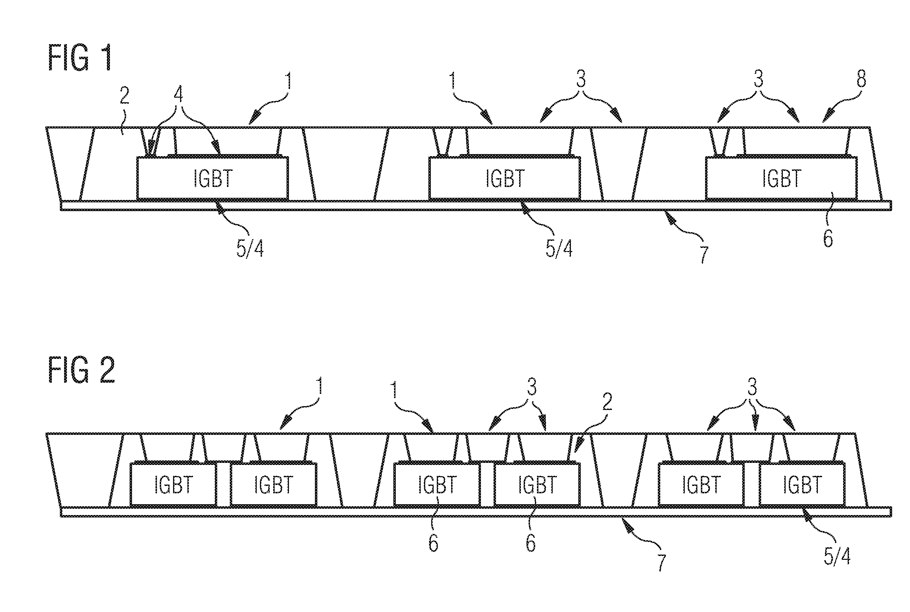

Figur 1 zeigt ein erstes Ausführungsbeispiel einer Vielzahl von Einzelpackages 1. Gemäß diesem Ausführungsbeispiel weist ein Einzelpackage 1 einen IGBT (Insulated Gate Bipolar Transistor) als ungehäustes Bauelement 6 mit dazugehörigen Anschlussflächen zur elektrischen Kontaktierung 4 und zur Befestigung 5 auf einer Trägerfolie 7 auf. Die IGBTs sind auf der Trägerfolie 7 angeordnet und mit einer Bauelementumhüllung 2 vergossen. Jedes Einzelpackage 1 ist hinsichtlich bestimmter Eigenschaften einheitlich normiert, und zwar weist jedes Einzelpackage 1 die gleiche normierte elektrisch isolierende Bauelementumhüllung 2 auf. Jedes Einzelpackage 1 weist eine elektrisch isolierende Bauelementumhüllung 2 mit einer einheitlich normierten äußeren geometrischen Form und einheitlich normierten Abmessungen auf. Jedes Einzelpackage 1 weist die gleiche Bauelementzusammenstellung auf und die elektrisch isolierende Bauelementumhüllung 2 ist jeweils mit einheitlich normierten Zugängen 3 zu den Anschlussflächen 4, 5 bereitgestellt. Jedes Einzelpackage 1 weist als elektrisch isolierende Bauelementumhüllung 2 ein einheitlich normiertes elektrisch isolierendes Material mit an ein Substrat 7a angepassten thermischen Ausdehungskoeffizienten auf. Jedes Einzelpackage 1 weist die elektrisch isolierende Bauelementumhüllung 2 mit einheitlich normiertem hoch temperaturfestem Material und/oder einem Material mit einer einheitlich normierten Dielektrizitätszahl auf. Gemäß Fig. 1 sind die Einzelpackages 1 auf der Trägerfolie 7 derart fixiert, dass ein sogenannter Gurt für Pick-and-Place-Maschinen ausgebildet wird. In derartigen Maschinen werden die Einzelpackages 1 abgehoben und auf ein Substrat 7a, beispielsweise eine Leiterplatte einer Vorrichtung, gesetzt, elektrisch kontaktiert und befestigt. Jedes Einzelpackage 1 weist Anschlussflächen 4, 5 auf, die einheitlich normiert löt- und/oder schweißbar sind. Jedes Einzelpackage 1 weist die Anschlussflächen 4 zur elektrischen Kontaktierung einheitlich normiert planar oder oberflächenmontiert aus der Bauelementumhüllung 2 herausgeführt auf. Jedes Einzelpackage 1 weist die Bauelementzusammenstellung hinsichtlich deren Funktion einheitlich normiert auf. Die gemäß Fig. 1 dargestellten Einzelpackages 1 können beispielsweise zur Gleichrichtung oder Wechselrichtung in der Leistungselektronik verwendet werden. Alle vorstehend beschriebenen Einteilungen in einheitlich normierte Leistungspackages 1 können sowohl kumulativ als auch alternativ geschaffen sein.

Figur 2 zeigt ein zweites Ausführungsbeispiel erfindungsgemäßer Einzelpackages 1, wobei jedes Einzelpackage 1, eine zur Fig. 1 identische elektrisch isolierende Bauelementumhüllung 2 mit einer einheitlich normierten äußeren geometrischen Form und einheitlich normierten Abmessungen aufweist. Da die Bauelementzusammenstellung von der der Fig. 1 abweicht und zwei IGBTs in einem Einzelpackage 1 erzeugt sind, weist die elektrisch isolierende Bauelementumhüllung 2 zur Fig. 1 abweichende einheitlich normierten Zugängen 3 zu den Anschlussflächen 4, 5 auf. Die Einzelpackages 1 können hinsichtlich der weiteren Eigenschaften entsprechend den Einzelpackages 1 nach Fig. 1 einheitlich normiert bereitgestellt sein.

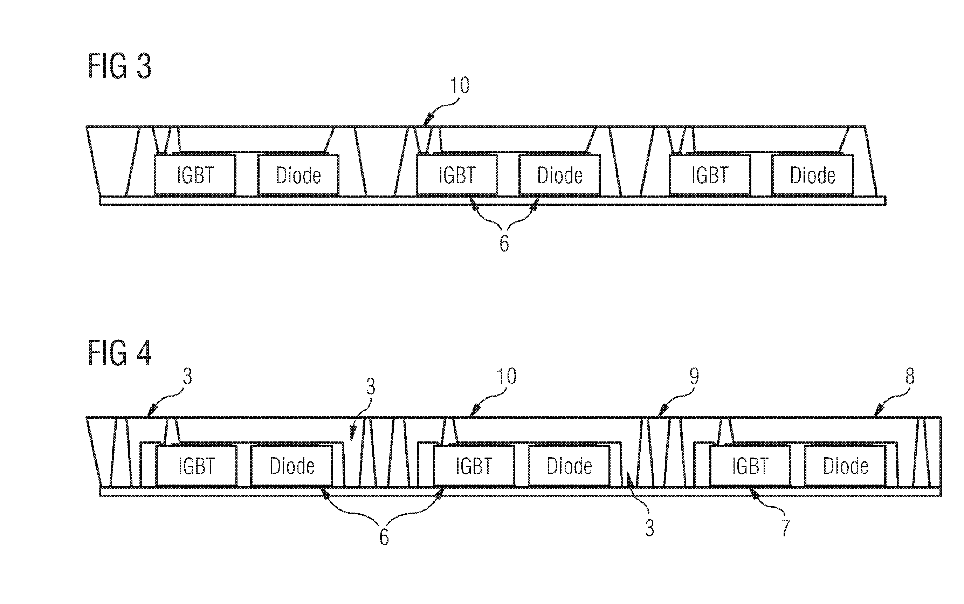

Figur 3 zeigt ein drittes Ausführungsbeispiel einer Vielzahl von Einzelpackages 1, wobei jedes Einzelpackage 1 eine zur Fig. 1 und Fig. 2 identische elektrisch isolierende Bauelementumhüllung 2 mit einer einheitlich normierten äußeren geometrischen Form und einheitlich normierten Abmessungen aufweist. Da die Bauelementzusammenstellung von der der Fig. 1 und Fig. 2 abweicht und ein IGBT und eine Diode in einem Einzelpackage 1 erzeugt sind, weist die elektrisch isolierende Bauelementumhüllung 2 zur Fig. 1 und Fig. 2 abweichende einheitlich normierte Zugänge 3 zu den Anschlussflächen 4, 5 auf. Die Einzelpackages 1 können hinsichtlich der weiteren Eigenschaften entsprechend den Einzelpackages 1 nach Fig. 1 einheitlich normiert bereitgestellt sein.

Figur 4 zeigt ein viertes Ausführungsbeispiel einer Vielzahl von Einzelpackages 1, wobei jedes Einzelpackage 1 eine zur Fig. 1, 2 und 3 identische elektrisch isolierende Bauelementumhüllung 2 mit einer einheitlich normierten äußeren geometrischen Form und einheitlich normierten Abmessungen aufweist. Da die Bauelementzusammenstellung von der der Fig. 1 und Fig. 2 abweicht und ein IGBT und eine Diode in einem Einzelpackage 1 erzeugt sind, weist die elektrisch isolierende Bauelementumhüllung 2 zur Fig. 1 und Fig. 2 abweichende einheitlich normierte Zugänge 3 zu den Anschlussflächen 4, 5 auf. Die Einzelpackages 1 können hinsichtlich der weiteren Eigenschaften entsprechend den Einzelpackages 1 nach Fig. 1 einheitlich normiert bereitgestellt sein.

Gemäß den Fig. 1 bis 4 können die Anschlussflächen 4 und 5 auf der, der Trägerfolie 7 abgewandten Seite mittels des in der WO 03030247 beschriebenen Verfahrens planar elektrisch kontaktiert werden. Dabei werden Zugänge 3 nicht lediglich mittels Ablasern der Restschichtdicke des umgebenden Kunststoffes, sondern mittels der Prozessschritte gemäß der WO 03030247 erzeugt. Beispielsweise sind diese Schritte vollflächiges Sputtern einer Basismetallisierung, Aufbringen, Belichten und Entwickeln einer lichtempfindlichen Schicht, Galvanisieren der Zugänge 3, Entfernen der lichtempfindlichen Schicht, Rückätzen der Basismetallisierung, abschließendes Erzeugen eines metallischen, insbesondere Kupfer aufweisenden, Zugangs 3.

Gemäß den Figuren 1 bis 4 enden galvanisierte Zugänge 3 auf der Oberseite eines Einzelpackages 1. Gemäß dieser Ausführungsform kann ein Einzelpackage 1 auf der oberen Seite beispielsweise mittels Schweißverfahren, insbesondere Laserschweißverfahren, kontaktiert werden. Gemäß Fig. 1 bis 4 sind Rinnen 10 oder im Querschnitt V- oder U-förmige Aussparungen von der Oberseite der Einzelpackages 1 zu den Anschlussflächen 4, 5 auf der Oberseite des jeweiligen Bauelements 6 ausgebildet. Bei Ausbildung der genormten Zugänge 3 als Rinne 10, kann der galvanisierte Zugang 3 jeweils formschlüssig mit der Spritzgußumhüllung 2 abschließen.

Fig. 4 zeigt zudem, abweichend zu Fig. 1 bis 3, einheitlich normierten Zugänge 3 zu den Anschlussflächen 4, 5 in Form eines galvanisierten Zugangs 3 durch die Bauelementumhüllung 2 hindurch, von der Oberseite zur Unterseite des jeweiligen Bauelements 6. Auf diese Weise können bei der Montage dieser Einzelpackages 1 alle Kontakte auf der Bauteilrückseite beziehungsweise Bauteilunterseite in einem Schritt kontaktiert beziehungsweise gelötet werden. Eine weitere Alternative ist ein galvanisierter Zugang 3 auf der Oberfläche der Bauelementumhüllung 2 von der Oberseite zur Unterseite des Bauelements 6. Diese Alternative ist nicht dargestellt.

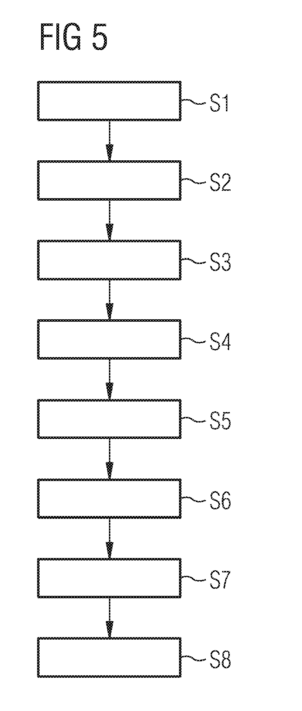

Fig. 5 zeigt ein Ausführungsbeispiel eines Verfahrens zur Erzeugung einer Vielzahl von Einzelpackages 1 mit jeweils einer bestimmten Bauelementzusammenstellung und deren Weiterverarbeitung. Zuerst erfolgt in einem Schritt S1 ein Fixieren der jeweils einem Einzelpackage 1 zugeordneten ungehäusten Bauelemente 6 mit deren Anschlussflächen 5 zur Befestigung auf einer Trägerfolie 7. Mit einem Schritt S2 erfolgt ein Erzeugen jeweils eines hinsichtlich beliebiger Eigenschaften einheitlich normierten Einzelpackages 1, insbesondere mit einer einheitlich normierten elektrisch isolierenden Bauelementumhüllung 2 für jedes Einzelpackage 1, auf allen Flächen der den Einzelpackages 1 zugeordneten ungehäusten Bauelementen 6, außer deren Anschlussflächen 5 zur Befestigung auf der Trägerfolie 7. Mit den Schritten S1 und S2 ist ein Erzeugen von gleichen Einzelpackages 1 mit gleicher Bauelementzusammmenstellung auf der gleichen Trägerfolie 7 besonders für die Erzeugung von sogenannten Gurten besonders vorteilhaft. Ebenso ist ein gleichzeitiges Erzeugen der Vielzahl von Einzelpackages 1 auf der Trägerfolie 7 aufgrund der Zeitersparnis vorteilhaft. Bei dem Schritt S2 ist ein Erzeugen der Bauelementumhüllung 2 mittels Molding, Vergießens oder Spritzguss vorteilhaft. Mit einem Schritt S3 erfolgt ein Erzeugen der Zugänge 3 zu Anschlussflächen 4, 5, insbesondere zur elektrischen Kontaktierung 4, mittels in Fig. 1 dargestellter erster Aussparungen 8 in der Bauelementumhüllung 2. Bei Schritt S3 ist ein Erzeugen der Zugänge 3 zu Anschlussflächen 4, 5, insbesondere zur elektrischen Kontaktierung 4, mittels Bereitstellen der Bauelementumhüllung 2 mit, einer im Vergleich zu einer durchschnittlichen Dicke, kleinen Dicke und anschließendem Entfernen dieses Restes mittels Ablation, insbesondere Laserablation besonders einfach. Mit einem Schritt S4 erfolgt ein Erzeugen von Vereinzelungspositionen zwischen angrenzenden Einzelpackages 1 mittels in Fig. 1 dargestellter zweiter Aussparungen 9 und/oder Ausdünnungen in der Bauelementumhüllung 2. Nach dem Schritt S4 können die fertigen Einzelpackages 1 auf einer Trägerfolie 7 in Form eines Gurtes aufgerollt und damit für Pick- and Place-Maschinen verwendbar erzeugt werden. Mit einem Schritt S5 erfolgt ein Abnehmen von erzeugten Einzelpackages 1 von der Trägerfolie 7 mittels Pick- and Place-Maschinen. Bei dem Schritt S6 erfolgt mittels der Anschlussflächen 5 zur Befestigung und elektrischen Kontaktierung 4 erfolgendes Aufbringen von Einzelpackages 1 auf jeweilige Substrate 7a, insbesondere Leiterplatten, beliebiger Vorrichtungen. Ein Schritt S7 betrifft das Befestigen von Einzelpackages 1 mittels Löten und/oder Schweißen auf jeweiligen Substraten 7a, insbesondere Leiterplatten 7a, beliebiger Vorrichtungen. Mit einem letzten Schritt S8 erfolgt ein Erzeugen von aus der Bauelementumhüllung 2 herausgeführten Anschlussflächen 4 zur elektrischen Kontaktierung planar oder oberflächenmontiert (SMT). Auf diese Weise können Leistungshalbleiterbauelemente oder Hochleistungshalbleiterbauelemente, insbesondere für den Hochspannungsbereich größer 1000V, einfach geschaffen und beispielsweise in Funktion als Wechselrichter, Gleichrichter, Gleichstromsteller, Frequenzumformer und dergleichen verwendet werden.

## Patentansprüche

1. Vielzahl von Einzelpackages (1) mit jeweils einer Bauelementzusammenstellung mit mindestens einem elektronischen Bauelement (6), wobei das Bauelement (6) Anschlussflächen zur elektrischen Kontaktierung (4) des Bauelements (6) und zur Befestigung (5) des Bauelements (6) aufweist, wobei
die Einzelpackages (1) hinsichtlich bestimmter Eigenschaften einer elektrisch isolierenden Bauelementumhüllung (2) in Gruppen eingeteilt sind,
**dadurch gekennzeichnet, dass**
jedes Einzelpackage (1), unabhängig von der Bauelementzusammenstellung, je Gruppe eine elektrisch isolierende Bauelementumhüllung (2) mit einer äußeren geometrischen Form und einheitlichen Abmessungen aufweist.

2. Vielzahl von Einzelpackages (1) nach Anspruch 1,
**dadurch gekennzeichnet, dass**
jedes Einzelpackage (1), bei gleicher Bauelementzusammenstellung, je Gruppe die elektrisch isolierende Bauelementumhüllung (2) mit einheitlichen Zugängen (3) zu den Anschlussflächen (4, 5) aufweist.

3. Vielzahl von Einzelpackages (1) nach Anspruch 2,
**dadurch gekennzeichnet, dass**
die einheitlichen Zugänge (3) zu den Anschlussflächen (4, 5) eine Durchführung durch die Bauelementumhüllung (2) von der Oberseite zur Unterseite des Bauelements (6), eine Zuführung auf der Oberfläche der Bauelementumhüllung (2) von der Oberseite zur Unterseite des Bauelements (6) und/oder eine Rinne von der Oberseite des Einzelpackages (1) zu den Anschlussflächen (4, 5) auf der Oberseite des Bauelements (6) aufweisen.

4. Vielzahl von Einzelpackages (1) nach Anspruch 1, 2 oder 3,
**dadurch gekennzeichnet, dass**
bei jedem Einzelpackage (1) je Gruppe, die elektrisch isolierende Bauelementumhüllung (2) ein einheitliches elektrisch isolierendes Material mit an ein Substrat (7a) angepasstem thermischen Ausdehungskoeffizienten aufweist.

5. Vielzahl von Einzelpackages (1) nach einem der Ansprüche 1 bis 4,
**dadurch gekennzeichnet, dass**
bei jedem Einzelpackage (1) je Gruppe, die elektrisch isolierende Bauelementumhüllung (2) ein einheitliches hoch temperaturfestes Material und/oder einen Material mit einer einheitlichen Dielektrizitätszahl aufweist.

6. Vielzahl von Einzelpackages (1) nach einem der Ansprüche 1 bis 5,
**dadurch gekennzeichnet, dass**
bei jedem Einzelpackage (1) je Gruppe, die Anschlussflächen (4, 5) einheitlich löt- und/oder schweißbar sind.

7. Vielzahl von Einzelpackages (1) nach einem der vorangehenden Ansprüche 1 bis 6,
**dadurch gekennzeichnet, dass**
bei jedem Einzelpackage (1) je Gruppe, die Anschlussflächen (4) zur elektrischen Kontaktierung einheitlich planar oder oberflächenmontiert entlang der Zugänge (3) aus der Bauelementumhüllung (2) herausgeführt sind.

8. Vielzahl von Einzelpackages (1) nach einem der vorangehenden Ansprüche 1 bis 7,
**dadurch gekennzeichnet, dass**
bei jedem Einzelpackage (1) je Gruppe, die Bauelementzusammenstellung hinsichtlich deren Funktion einheitlich ist.

9. Verfahren zur Erzeugung einer Vielzahl von Einzelpackages (1) mit jeweils einer Zusammenstellung von Bauelementen (6), nach einem der vorangehenden Ansprüche 1 bis 8, mit den Schritten
- Fixieren der Bauelemente (6) mit deren Anschlussflächen zur Befestigung (5) auf einer Trägerfolie (7), und
- Erzeugen jeweils eines Einzelpackages (1) auf allen Flächen der Bauelemente (6), außer deren Anschlussflächen zur Befestigung (5) auf der Trägerfolie (7), wobei die Einzelpackages (1) hinsichtlich bestimmter Eigenschaften einer elektrisch isolierenden Bauelementumhüllung (2) für jedes Einzelpackage (1) in Gruppen eingeteilt werden,
**dadurch gekennzeichnet, dass**
jedes Einzelpackage (1), unabhängig von der Bauelementzusammenstellung, je Gruppe eine elektrisch isolierende Bauelementumhüllung (2) mit einer äußeren geometrischen Form und einheitlichen Abmessungen aufweist.

10. Verfahren nach Anspruch 9,
**gekennzeichnet durch**
Erzeugen von gleichen Einzelpackages (1) mit gleicher Zusammenstellung der Bauelemente (6) auf der gleichen Trägerfolie (7) .

11. Verfahren nach Anspruch 9 oder 10,
**gekennzeichnet durch**
gleichzeitiges Erzeugen der Vielzahl von Einzelpackages (1) auf der Trägerfolie (7).

12. Verfahren nach Anspruch 9, 10 oder 11,
**gekennzeichnet durch**
Erzeugen der Bauelementumhüllung (2) mittels Molding, Vergießens oder Spritzguss.

13. Verfahren nach einem oder mehreren der Ansprüche 9 bis 12, **gekennzeichnet durch**
Erzeugen der Zugänge (3) zu Anschlussflächen zur elektrischen Kontaktierung (4) mittels erster Aussparungen (8) in der Bauelementumhüllung (2).

14. Verfahren nach einem oder mehreren der Ansprüche 9 bis 13, **gekennzeichnet durch**
Erzeugen der Zugänge (3) zu Anschlussflächen zur elektrischen Kontaktierung (4), mittels Bereitstellen der Bauelementumhüllung (2) mit, einer im Vergleich zu einer durchschnittlichen Dicke, kleinen Dicke und anschließendem Entfernen dieses Restes mittels Ablation.

15. Verfahren nach Anspruch 14,
**gekennzeichnet durch** nach dem Entfernen erfolgendes
- vollflächiges Sputtern einer Basismetallisierung;
- Aufbringen, Belichten und Entwickeln einer lichtempfindlichen Schicht;
- Galvanisieren der Zugänge (3),
- Entfernen der lichtempfindlichen Schicht;
- Rückätzen der Basismetallisierung,
- abschließendes Erzeugen von metallischen Zugängen (3).

16. Verfahren nach einem oder mehreren der Ansprüche 9 bis 15, **gekennzeichnet durch**
Erzeugen von Vereinzelungspositionen zwischen angrenzenden Einzelpackages (1) mittels zweiter Aussparungen (9) oder Ausdünnungen in der Bauelementumhüllung (2).

17. Verfahren nach einem oder mehreren der Ansprüche 9 bis 16, **gekennzeichnet durch**
Abnehmen von erzeugten Einzelpackages (1) von der Trägerfolie (7) mittels Pick- and Place-Maschinen.

18. Verfahren nach einem oder mehreren der Ansprüche 9 bis 17, **gekennzeichnet durch**
mittels der Anschlussflächen (5) zur Befestigung erfolgendes Aufbringen von Einzelpackages (1) auf jeweilige Substrate (7a) beliebiger Vorrichtungen.

19. Verfahren nach einem oder mehreren der Ansprüche 9 bis 18, **gekennzeichnet durch**
Befestigen von Einzelpackages (1) mittels Löten oder Schweißen der Anschlussflächen zur elektrischen Kontaktierung (4) und zur Befestigung (5) auf jeweiligen Substraten (7a) beliebiger Vorrichtungen.

20. Verfahren nach einem oder mehreren der Ansprüche 9 bis 19, **gekennzeichnet durch**
planares oder oberflächenmontiertes (SMT) Erzeugen von aus der Bauelementumhüllung (2) herausgeführten, einheitlichen metallischen Zugängen (3) zur elektrischen Kontaktierung.
